# EUROPEAN PATENT SPECIFICATION

(11) **EP 4 549 638 B1**
(45) Date of publication and mention of the grant of the patent: **10.06.2026**
(21) Application number: 24761478.7
(22) Date of filing: 29.04.2024
(51) Int. Cl.: C30B 29/36, C30B 23/00, C30B 23/06

(54) **APPARATUS AND METHOD FOR GROWING HIGH-QUALITY SILICON CARBIDE CRYSTALS**
VORRICHTUNG UND VERFAHREN ZUR ZÜCHTUNG VON SILICIUMCARBIDKRISTALLEN HOHER QUALITÄT
APPAREIL ET PROCÉDÉ DE CROISSANCE DE CRISTAUX DE CARBURE DE SILICIUM DE HAUTE QUALITÉ

(30) Priority: 19.06.2023 CN 202310722010
(43) Date of publication of application: 07.05.2025
(73) Proprietor: Tongwei Microelectronics Co., Ltd., Chengdu, Sichuan 610299 (CN)
(72) Inventor: LIN, Yuyi, Chengdu, Sichuan 610229 (CN); LIU, Xi, Chengdu, Sichuan 610229 (CN); YU, Mingxuan, Chengdu, Sichuan 610229 (CN); CHEN, Zengqiang, Chengdu, Sichuan 610229 (CN)
(74) Representative: Garavelli, Paolo
(86) International application number: PCT/CN2024/090492
(87) International publication number: WO 2024/260107

(56) References cited:
- EP-B1- 2 388 359
- WO-A1-2023/082913
- CN-A- 110 004 486
- CN-A- 116 463 728
- CN-U- 211 284 619
- CN-U- 211 284 619
- JP-A- 2021 088 476
- US-B2- 11 453 959

## Description

### TECHNICAL FIELD

The present disclosure relates to the field of silicon carbide crystal growth, in particular to an apparatus and a method for growing high-quality silicon carbide crystals.

### BACKGROUND ART

Silicon carbide, which is a representative of third-generation semiconductor materials, has excellent properties such as large forbidden bandwidth, high saturated electron mobility, high puncture field intensity, high thermal conductivity, and the like, and has been widely used in fields of power electronics, radio frequency devices, optoelectronic devices, and the like.

A method for growing the silicon carbide mainly includes a physical vapor transport method (PVT), a liquid phase epitaxy method (LPE), a chemical vapor deposition method (CVD), and the like, wherein the PVT method is the most mature method. The existing crystal growth apparatus used by the PVT method generally involves two types of induction heating and resistance heating, wherein the induction heating has the advantages of simple structure, high heating efficiency, high heating speed, no pollution, and the like, however, it has problems of unreasonable temperature gradient and influence on the rate and quality of crystal growth. An example of such an existing growth apparatus is disclosed in US11453959B2, where induction heating is used and a specific structure of the crucible leads to an axial temperature gradient.

### SUMMARY

An objective of the present disclosure is to, for example, provide an apparatus and method for growing high-quality silicon carbide crystals that are effective in increasing the axial temperature gradient to elevate the crystal growth rate while reducing the radial temperature gradient to improve the crystal growth quality.

Embodiments of the present disclosure may be implemented as follows:
in a first aspect, the present disclosure provides an apparatus for growing high-quality silicon carbide crystals, including:
a crucible, a seed crystal being arranged on a top of the crucible;
a thermal insulation layer, the thermal insulation layer being arranged on an outer side of the crucible;
an induction coil, the induction coil surrounding the thermal insulation layer; and
an induction heating ring, the induction heating ring being arranged in the thermal insulation layer and surrounding the seed crystal, and an inner wall of the induction heating ring and an outer wall of the crucible being spaced apart from each other and insulated by the thermal insulation layer.

In an optional implementation, the crucible includes a discharge section and a crystal growth section which are connected sequentially from bottom to top, a diameter of the crystal growth section is smaller than that of the discharge section, such that the crucible is in a stepped pattern, the induction heating ring surrounds the crystal growth section, and the seed crystal is arranged on a top of the crystal growth section.

In an optional implementation, an inner diameter of the induction heating ring remains constant or gradually gets increased in a bottom-up direction.

In an optional implementation, the induction heating ring includes a first annular portion and a second annular portion, the first annular portion surrounds the seed crystal, an outer peripheral wall of the second annular portion is connected to a top of the first annular portion, and an inner peripheral wall of the second annular portion extends toward an axis of the crucible.

In an optional implementation, a first cavity is formed between the top of the crucible and the thermal insulation layer, and the inner peripheral wall of the second annular portion extends into the first cavity.

In an optional implementation, the inner peripheral wall of the second annular portion extends to a position above the seed crystal.

In an optional implementation, a height of the second annular portion remains constant or gradually gets decreased in a direction from the outer peripheral wall to the inner peripheral wall.

In an optional implementation, the apparatus for growing the high-quality silicon carbide crystals further includes an auxiliary heating ring, wherein the auxiliary heating ring is positioned below the induction heating ring and surrounds the crucible, an inner wall of the auxiliary heating ring is spaced apart from the outer wall of the crucible, a second cavity is formed between a lower surface of the crucible and the thermal insulation layer, and the auxiliary heating ring is positioned in the second cavity.

In a second aspect, the present disclosure further provides a method for growing high-quality silicon carbide crystals, and based on the apparatus for growing the high-quality silicon carbide crystals provided by any one of the implementations, the method includes:
placing silicon carbide powder in the crucible;
pumping air from the crucible and then filling inert gases;
energizing the induction coil to heat the crucible so as to raise a temperature inside the crucible to 2000-2600°C;
exhausting the crucible again to reduce a pressure inside the crucible to 0.01-4E3 Pa;
sublimating the silicon carbide powder and starting to grow the silicon carbide crystals on the seed crystal;
after the silicon carbide crystals grow for 10-300 h, filling the inert gases into the crucible again to elevate the pressure inside the crucible to 5E3-1E5 Pa; and
at the end of the growth of the silicon carbide crystals, de-energizing the induction coil, and taking out the silicon carbide crystals from the crucible after the temperature inside the crucible is reduced to a room temperature.

In a third aspect, the present disclosure further provides silicon carbide crystals, which are prepared through the method for growing the high-quality silicon carbide crystals as described in the implementations.

The embodiments have the following beneficial effects, for example,

The apparatus for growing the high-quality silicon carbide crystals includes the crucible, the thermal insulation layer, the induction coil and the induction heating ring, the seed crystal is arranged on the top of the crucible, the thermal insulation layer is arranged on the outer side of the crucible, the induction coil surrounds the thermal insulation layer, the induction heating ring is arranged in the thermal insulation layer and surrounds the seed crystal, and the inner wall of the induction heating ring and the outer wall of the crucible are spaced apart from each other and insulated by the thermal insulation layer. By additionally arranging the induction heating ring on the top of the crucible, the magnetic field on the top of the crucible can be changed when the induction coil is energized, such that heat generated on the top of the crucible is reduced, and the temperature decreases, thus increasing the axial temperature gradient of the crucible, elevating the growth rate of the silicon carbide crystals, while reducing the radial temperature gradient of the crucible, and improving the growth quality of the silicon carbide crystals.

Accordingly, the method for growing the high-quality silicon carbide crystals can improve the growth rate and quality of the silicon carbide crystals by utilizing the above apparatus.

### BRIEF DESCRIPTION OF THE DRAWINGS

In order to more clearly explain the technical solutions of embodiments of the present disclosure, drawings required to be used in the embodiments will be briefly described below, it should be understood that the following drawings only illustrate some embodiments of the present disclosure, and thus should not be regarded as limitations to the scope, and according to which, those ordinarily skilled in the art can also obtain other drawings without involving inventive efforts.
FIG. 1 is a schematic structural diagram illustrating an apparatus for growing high-quality silicon carbide crystals according to Embodiment 1 of the present disclosure;
FIG. 2 is a schematic structural diagram illustrating another apparatus for growing high-quality silicon carbide crystals according to Embodiment 1 of the present disclosure;
FIG. 3 is a schematic structural diagram illustrating an apparatus for growing high-quality silicon carbide crystals according to Embodiment 2 of the present disclosure;
FIG. 4 is a schematic structural diagram illustrating another apparatus for growing high-quality silicon carbide crystals according to Embodiment 2 of the present disclosure; and
FIG. 5 is a schematic structural diagram illustrating an apparatus for growing high-quality silicon carbide crystals according to Embodiment 3 of the present disclosure.

Drawing sign: 100-Crucible; 102-Discharge section; 104-Crystal growth section; 110-Seed crystal; 200-Thermal insulation layer; 300-Induction coil; 400-Induction heating ring; 410-First annular portion; 420-Second annular portion; 500-First cavity; 600-Second cavity; 700-Auxiliary heating ring; and 800-Silicon carbide powder.

### DETAILED DESCRIPTION OF THE EMBODIMENTS

In order to make the objectives, technical solutions and advantages of the embodiments of the present disclosure clearer, the technical solutions in the embodiments of the present disclosure will be described clearly and completely with reference to the drawings in the embodiments of the present disclosure. Apparently, the described embodiments are part of the embodiments, not all of the embodiments. The components of the embodiments of the present disclosure generally described and illustrated in the drawings herein may be arranged and designed in a wide variety of different configurations.

Thus, the following detailed description of the embodiments of the present disclosure, as presented in the drawings, is not intended to limit the scope of the present disclosure, as claimed, but is merely representative of selected embodiments of the present disclosure. All other embodiments obtained by those ordinarily skilled in the art based on the embodiments of the present disclosure without involving inventive efforts should fall within the protection scope of the present disclosure.

It should be noted that like reference numerals and letters denote like items in the following drawings, and thus once an item is defined in one drawing, no further definition or explanation thereof is necessary in the following drawings.

In the description of the present disclosure, it should be understood that orientation or position relationships indicated by terms "upper", "lower", "left", "right", "inner", "outer", and the like are orientation or position relationships shown in the drawings, or orientation or position relationships based on which products of the present disclosure are usually placed, are adopted not to indicate or imply that indicated devices or elements must be in specific orientations or structured and operated in specific orientations but only to conveniently describe the present disclosure and simplify the description, and thus should not be understood as a limitation to the present disclosure.

In addition, terms "first", "second", and the like are merely used for distinguishing between descriptions and should not be understood as the indication or implication of relative importance.

It should be noted that the features in the embodiments of the present disclosure may be mutually combined without conflicts.

Currently, two heating methods, namely induction heating and resistance heating, are mainly adopted for the growth of silicon carbide crystals. Wherein the induction heating, by utilizing an electromagnetic induction effect, allows for a crucible to serve as a heat source for providing heat for the sublimation of silicon carbide powder in the crucible. The induction heating has the advantages of simple structure, high heating efficiency, high heating speed, no pollution, and the like. However, a skin effect results in the heat generated by the induction heating being predominantly concentrated on an outer peripheral surface of the crucible. Consequently, this causes a reduced axial temperature gradient and an excessively large radial temperature gradient during the growth process of the silicon carbide crystals. The diminished axial temperature gradient will affect the growth rate of the silicon carbide crystals, whereas the significant radial temperature gradient will induce increased internal stress of the silicon carbide crystals, leading to defects such as dislocation, and consequently, heightening the cracking risk of the silicon carbide crystals that results in quality concerns.

The resistance heating refers to the heating of an object to be heated by thermal energy generated by a joule effect when an electric current flows through a resistor. By taking a graphite heater as an example, the graphite heater generates the heat upon the energization of direct current or alternating current, which is then transferred to the crucible through thermal radiation and convection. The heating effect is better and more uniform because the heater does not come into direct contact with the crucible, resulting in a significantly reduced radial temperature gradient during crystal growth compared to induction heating, but the structure is complex leading to higher costs, and there is an increased likelihood of an arcing problem.

In view of the above, the present disclosure provides an apparatus and method employing induction heating, which may improve the crystal growth quality and accelerate the crystal growth rate while maintaining the advantages of induction heating. In the apparatus for growing the high-quality silicon carbide crystals, by additionally arranging an induction heating ring on a top of the crucible, a magnetic field on the top of the crucible is changed when an induction coil is energized, such that heat generated on the top of the crucible is reduced, a temperature decreases, and a temperature difference between the top of the crucible and middle and lower portions of the crucible is increased, thus increasing the axial temperature gradient of the crucible, promoting the rapid growth of the silicon carbide crystals, and accelerating the growth rate. Meanwhile, due to a temperature decrease at the periphery of the top of the crucible, it inevitably leads to a reduction in the radial temperature difference on the top of the crucible, thus reducing the radial temperature gradient within the crucible. This reduction is conducive to the uniform growth of the silicon carbide crystals in the radial direction, and enhances the growth quality.

The structure, principle and effect of the apparatus for growing the high-quality silicon carbide crystals and the detailed steps of the corresponding method provided by the present disclosure are described in detail below by way of embodiments with reference to the drawings.

### Embodiment 1

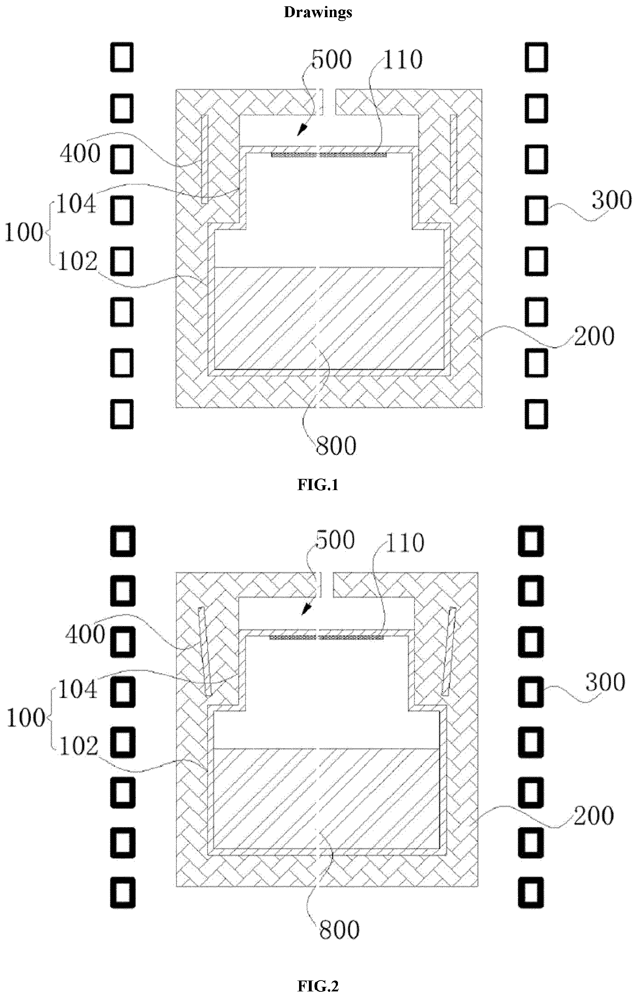

Referring to FIG. 1 or FIG. 2, an apparatus for growing high-quality silicon carbide crystals according to the present disclosure includes a crucible 100, a thermal insulation layer 200, an induction coil 300, and an insulation heating ring 400.

Wherein the crucible 100 is made of graphite, and generates heat when the induction coil 300 is energized with current. A seed crystal 110 is arranged on a top of the crucible 100. The seed crystal 110 may be fixed by bonding, clamping, or the like, which is not particularly limited in this embodiment.

In this embodiment, the crucible 100 includes a discharge section 102 and a crystal growth section 104 which are connected sequentially from bottom to top, a diameter of the crystal growth section 104 is smaller than of the discharge section 102, such that the crucible 100 is in a stepped pattern, the crystal growth section 104 is formed on the top of the crucible 100, the discharge section 102 is formed on middle and lower portions of the crucible 100, and the seed crystal 110 is arranged on a top (i.e., a crucible cover) of the crystal growth section 104. The crucible 100, featuring a stepped structure that is narrower on a top and wider at a bottom, facilitating a higher temperature of the discharging section 102 compared to the crystal growth section 104 upon the heating of the crucible 100, thus improving an axial temperature gradient of the crucible 100 and improving the growth rate of silicon carbide crystals.

The thermal insulation layer 200 is arranged on an outer side of the crucible 100, and specifically, the thermal insulation layer 200 is wrapped on an outer wall of the crucible 100, so as to slow down the heat dissipation of the crucible 100 as much as possible, and provide a temperature environment that is required for the growth of the silicon carbide crystals within the crucible 100. A first cavity 500 is formed between the top of the crucible 100 and the thermal insulation layer 200, and specifically, an outer surface of the top of the crystal growth section 104 is not in direct contact with the thermal insulation layer 200, which, instead, is spaced apart from the thermal insulation layer to form the first cavity 500. With the arrangement of the first cavity 500, heat may be transferred uniformly on the top of the crystal growth section 104, thereby reducing the radial temperature gradient of the crystal growth section 104 and improving the growth quality of the silicon carbide crystals.

The insulation heating ring 400 is made of the graphite as well as the crucible 100. The insulation heating ring 400 is arranged in the thermal insulation layer 200 and surrounds the seed crystal 110, namely, the insulation heating ring 400 surrounds the crystal growth section 104. An inner wall of the insulation heating ring 400 is spaced apart from an outer wall of the crucible 100 and insulated by the thermal insulation layer 200, namely, the insulation heating ring 400 is not in direct contact with the outer wall of the crucible 100, and a part of the thermal insulation layer 200 is filled between the insulation heating ring and the crucible. Since the diameter of the crystal growth section 104 is smaller than that of the discharging section 102, a distance between the inner wall of the induction heating ring 400 and an outer wall of the crystal growth section 104 is relatively larger, the thermal insulation layer 200 between the inner wall of the induction heating ring and the outer wall of the crystal growth section is relatively thicker, the thermal insulation effect is better, and the heat of the induction heating ring 400 may be effectively prevented from being transferred to the crystal growth section 104 of the crucible 100.

Further, an axis of the induction heating ring 400 coincides with an axis of the crucible 100, such that every segment of the induction heating ring 400 is equidistant from a corresponding position of the outer wall of the crucible 100 in the radial direction. As a result, a magnetic field on the top of the crucible100 at different positions around a circumference may change uniformly, leading to a uniform reduction in the heat and a uniform decrease in temperature on the top of the crucible 100 around the circumference. In this way, it allows for the silicon carbide crystals on the seed crystal 110 to grow uniformly at different positions around the circumference, thus improving the growth quality.

Referring to FIG. 1 again, the specific structure of the induction heating ring 400 may be arranged as needed. In this embodiment, the inner diameter of the induction heating ring 400 remains constant in the bottom-up direction, that is, the induction heating ring 400 is entirely hollow and cylindrical, and an extending direction of the induction heating ring is parallel to the axis of the induction heating ring or an extending direction of the axis of the crucible 100. It should be noted that, referring to FIG. 2 again, in this embodiment, the inner diameter of the induction heating ring 400 may also gradually increase in the bottom-up direction, that is, the induction heating ring 400 is in an inverted hollow circular truncated cone shape, the extending direction of the induction heating ring has an included angle with the axis of the induction heating ring or the axis of the crucible 100, and the included angle may be set specifically as needed, for example, may be 5-15°, such that the heat generated by the portion of the crucible 100 that is surrounded by the induction heating ring 400 in the bottom-up direction gradually decreases, and the temperature gradually decreases, that is, the portion of the crucible 100 that is surrounded by the induction heating ring 400 also has an axial temperature gradient, such that the axial temperature gradient of the overall crucible 100 may be further improved, thus improving the growth rate of the silicon carbide crystals on the seed crystal 110.

The induction coil 300 surrounds the thermal insulation layer 200, and is connected with a power supply to facilitate the energization of current, thereby generating the heat from the crucible 100 and the induction heating ring 400 under an electromagnetic induction effect.

An operation principle and process of the apparatus for growing the high-quality silicon carbide crystals are as follows:

When the induction coil 300 is energized with the current, the crucible 100 generates heat under the electromagnetic induction effect, and becomes a heat source, such that silicon carbide powder 800 in the crucible 100 sublimates to form a vapor phase crystal growth component (mainly Sim Cn). The vapor phase crystal growth component rises to form the silicon carbide crystals on the seed crystal 110. The arrangement of the induction heating ring 400 may change the magnetic field on the top of the crucible 100, resulting in a reduction in heat generation on the top of the crucible 100 as compared to the middle and lower portions of the crucible 100 where the induction heating ring 400 is not arranged, namely, the heat generated by the crystal growth section 104 is reduced compared to the discharge section 102 (due to the skin effect of induction heating, an induced eddy current on the top of a thermal field is mainly positioned on the induction heating ring 400, such that the joule heat generated by the induction heating ring 400 is far more than that of an area where the crystal growth section 104 is located, and since the induction heating ring 400 and the crystal growth section 104 are insulated by the thermal insulation layer 200, the heat generated by the induction heating ring 400 will be greatly reduced when transferred to the crystal growth section 104, and as a result, the heat of the crystal growth section 104 is primarily derived from the thermal transfer of the discharge section 102, inevitably reducing the heat generated by the crystal growth section 104), such that the temperature of the crystal growth section 104 is lower than that of the discharge section 102, and the axial temperature difference of the crucible 100 is increased, namely, increasing the axial temperature gradient of the crucible 100, thus effectively improving the growth rate of silicon carbide crystals on the seed crystal 110. Meanwhile, a temperature decrease at the periphery of the top of the crucible 100 inevitably leads to a reduction in the radial temperature difference on the top of the crucible 100 at different positions, thus reducing the radial temperature gradient of the crucible 100, such that the silicon carbide crystals may grow uniformly at different positions in the radial direction, and the growth quality is improved.

The apparatus for growing the high-quality silicon carbide crystals may, by arranging the induction heating ring 400 around the top of the crucible 100, change the magnetic field on the top of the crucible 100 to reduce the heat generated on the top of the crucible 100, such that the temperature on the top of the crucible 100 is lower than the temperature on the middle and lower portions of the crucible 100, namely the temperature of the crystal growth section 104 is lower than the temperature of the discharge section 102. Consequently, this may increase the axial temperature gradient of the crucible 100 to effectively accelerate the growth rate of the silicon carbide crystals, while reducing the radial temperature gradient of the crucible 100, thus improving the growth quality of the silicon carbide crystals.

### Embodiment 2

The overall construction, operation principle and technical effects of the apparatus for growing the high-quality silicon carbide crystals according to this embodiment are substantially the same as those of Embodiment 1, except for the specific structure of the induction heating ring 400.

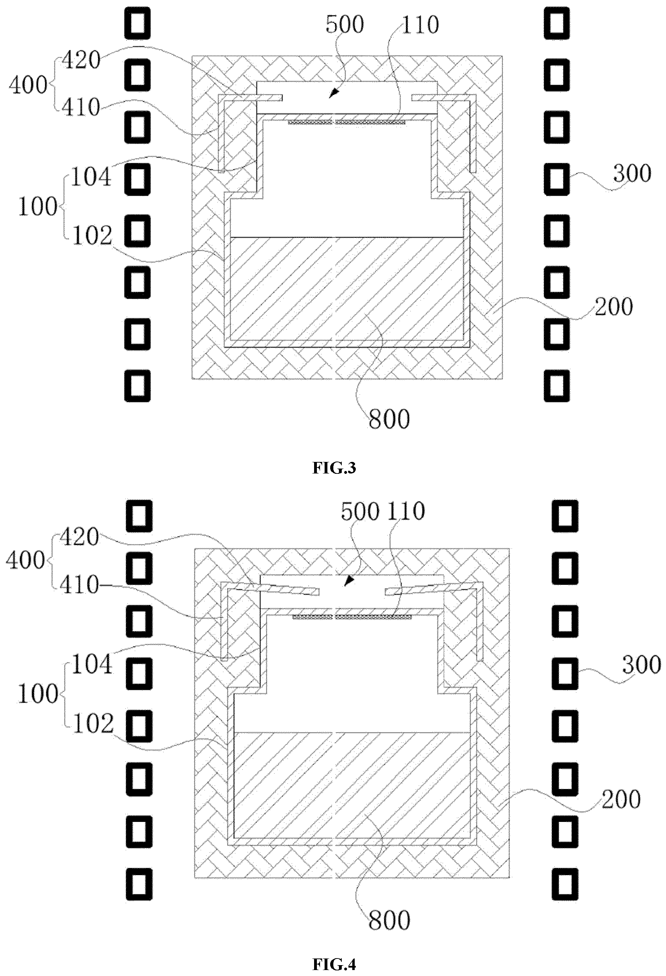

Referring to FIG. 3 or FIG. 4, in this embodiment, an induction heating ring 400 includes a first annular portion 410 and a second annular portion 420, the first annular portion 410 surrounds a seed crystal 110, namely, the first annular portion 410 surrounds a crystal growth section 104. An axis of the first annular portion 410 coincides with an axis of a crucible 100, and an inner wall of the first annular portion 410 and an outer wall of the crucible 100 are spaced apart from each other and insulated by a thermal insulation layer 200.

An axis of the second annular portion 420 also coincides with the axis of the crucible 100, and the overall second annular portion 420 is positioned above the crystal growth section 104. An outer peripheral wall of the second annular portion 420 is connected to a top of the first annular portion 410, and an inner peripheral wall of the second annular portion 420 extends toward the axis of the crucible 100, such that a cross section of the induction heating ring 400 at any position around the circumference is approximately in an inverted "L" shape, the first annular portion 410 is opposite to a circumferential surface of the crystal growth section 104 in the radial direction, and the second annular portion 420 is opposite to an end surface of the crystal growth section 104 in the axial direction.

Referring to FIG. 3, a relative position of the first annular portion 410 and a relative position of the second annular portion 420 may be set as needed. In this embodiment, the first annular portion 410 is hollow and cylindrical, and an extending direction of the first annular portion is parallel to the axis of the first annular portion or the axis of the crucible 100, and the inner peripheral wall of the second annular portion 420 extends into a first cavity 500 and extends to a position above the seed crystal 110. A height of the second annular portion 420 remains constant in a direction from the outer peripheral wall of the second annular portion 420 to the inner peripheral wall of the second annular portion 420, that is, the second annular portion 420 extends horizontally in a direction perpendicular to the axis of the second annular portion or the axis of the crucible 100.

For the induction heating ring 400 with the structure, the second annular portion 420 may regulate and control a heat transfer effect from the first annular portion 410 to the crystal growth section 104, since the first annular portion 410 becomes a primary heat source, the second annular portion 420 becomes a secondary heat source, and a radial temperature gradient of the crystal growth section 104 may be regulated and controlled by setting the shape and size of the second annular portion 420, such that the crystal growth section 104 may remain the smaller temperature gradient. Theoretically, the smaller the radial temperature gradient, the better the growth quality of the silicon carbide crystals, but when the radial temperature gradient is minimized to a certain extent, the crystal growth section 104 needs to remain a certain radial temperature gradient according to actual requirements so as to better control the growth shapes of the silicon carbide crystals, and further improve the growth quality of the silicon carbide crystals.

It should be noted that referring to FIG. 4 again, in this embodiment, the second annular portion 420 may also be in an inverted hollow circular truncated cone shape, and the extending direction of the second annular portion may have an included angle smaller than 90° with the axis of the second annular portion or the axis of the crucible 100, for example, may be 75° -85°, such that the radial temperature gradient of the crystal growth section 104 may be regulated as needed to control the growth shapes of the silicon carbide crystals, and further improve the growth quality of the silicon carbide crystals.

The connection method of the first annular portion 410 and the second annular portion 420 may also be set as needed. In this embodiment, the first annular portion 410 and the second annular portion 420 are of a split structure and are connected by a connecting member. In other embodiments, both the first annular portion and the second annular portion may be integrally formed.

### Embodiment 3

The overall construction, operation principle and technical effects of the apparatus for growing the high-quality silicon carbide crystals according to this embodiment are substantially the same as those of Embodiment 1 or Embodiment 2, except that the apparatus provided in this embodiment further includes an auxiliary heating ring 700, and the crucible 100 has the same diameter from bottom to top and does not exhibit a stepped structure.

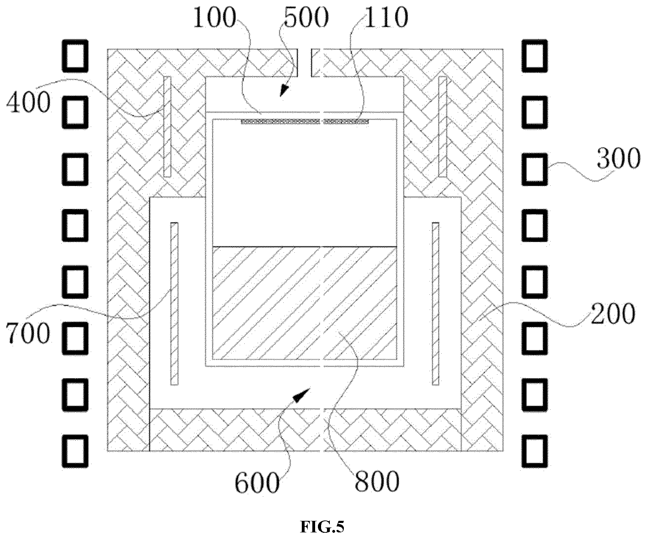

Referring to FIG. 5, in this embodiment, the auxiliary heating ring 700 is positioned below the induction heating ring 400 and surrounds the crucible 100, and an inner wall of the auxiliary heating ring 700 is spaced apart from an outer wall of the crucible 100. The auxiliary heating ring 700 is made of graphite, similar to the crucible 100 or the induction heating ring 400, so as to generate heat when the induction coil 300 is energized. The number of the auxiliary heating ring 700 may be set as needed. In this embodiment, only one auxiliary heating ring 700 is provided, and a bottom of the auxiliary heating ring extends to a position below a bottom of the crucible 100.

In other embodiments, a plurality of, for example, two or three, auxiliary heating rings 700 may further be provided, the plurality of auxiliary heating rings 700 may be spaced apart along an axis of the crucible 100. The plurality of auxiliary heating rings 700 operate cooperatively to realize the independent heating of the crucible 100 at different positions in the axial direction, such that the effect of resistance heating may be replicated with the use of a plurality of heaters for independent heating, defects of complicated structure and propensity of arcing in a low-pressure environment in the conventional resistance heating apparatus are overcome, the heating efficiency is high and the cost is reduced.

Further, in order to improve the heating uniformity of the lower portion of the crucible 100, in this embodiment, a second cavity 600 is formed between a lower surface of the crucible 100 and a thermal insulation layer 200, the second cavity 600 surrounds an outer surface of a lower portion of a side wall of the crucible 100 and an outer surface of a bottom wall of the crucible, and the auxiliary heating ring 700 is positioned in the second cavity 600 and is fixed by a mounting support (not shown). With the above arrangement, the characteristic of low thermal conductivity coefficient of gases may be utilized, and the heat generated by the auxiliary heating ring 700 may be uniformly transferred to different positions of middle and lower portions of the crucible 100 through gases (mainly Ar, N2, vapor phase crystal growth components, and the like) in the second cavity 600, thereby improving the uniformity of temperatures of the middle and lower portions of the crucible 100 at different positions, reducing the radial temperature gradient of the crucible 100, and improving the growth quality of silicon carbide crystals. Similarly, with such an arrangement, the heating effect of silicon carbide powder 800 near a center in the crucible 100 may also be improved, and the utilization rate of the silicon carbide powder 800 may be improved.

It should be noted that in other embodiments, auxiliary heating plates (not shown) may further be arranged at intervals below the bottom of the crucible 100, so as to further improve the heating effect in the center of the bottom of the crucible 100, thereby improving the temperature in the center of the bottom of the crucible 100, and further improving the heating effect on the silicon carbide powder 800 in the center of the crucible 100, and improving the utilization rate of the silicon carbide powder 800.

It should further be noted that the crucible 100 in this embodiment may also have a stepped structure as described in Embodiment 1 or Embodiment 2, so as to further increase the axial temperature gradient of the crucible 100, which may be specifically determined according to practical requirements.

### Embodiment 4

The embodiment of the present disclosure provides a method for growing high-quality silicon carbide crystals, which is based on the apparatus provided by Embodiment 1, Embodiment 2 or Embodiment 3, and specifically includes the following steps:
silicon carbide powder 800 is placed in a crucible 100;
air is pumped from the crucible 100 and then inert gases are filled;
the induction coil 300 is energized to heat the crucible 100 so as to raise a temperature inside the crucible 100 to 2000-2600°C;
the crucible 100 is exhausted again to reduce a pressure inside the crucible 100 to 0.01-4E3 Pa;
the silicon carbide powder 800 sublimates and the silicon carbide crystals start to grow on a seed crystal 110;
after the silicon carbide crystals grow for 10-300 h, the inert gases are filled into the crucible 100 again to elevate the pressure inside the crucible 100 to 5E3-1E5 Pa; and
at the end of the growth of the silicon carbide crystals, the induction coil 300 is de-energized, and the silicon carbide crystals are taken out of the crucible after the temperature inside the crucible 100 is reduced to a room temperature.

Wherein the rates of air pumping and air inflation are controlled through the coordination of a mechanical pump, a butterfly valve and a flowmeter.

### Embodiment 5:

The embodiment of the present disclosure provides silicon carbide crystals (i.e., crystal ingots), which are prepared through the method for growing the high-quality silicon carbide crystals provided by Embodiment 4, and the method has the characteristics of few defects and high quality.

The above descriptions are merely the detailed description of embodiments of the disclosure, which are not intended to limit the protection scope of the disclosure.

## Claims

1. An apparatus for growing high-quality silicon carbide crystals,
comprising
a crucible (100), a seed crystal (110) being arranged on a top of the crucible (100);
a thermal insulation layer (200), the thermal insulation layer (200) being arranged on an outer side of the crucible (100);
an induction coil (300), the induction coil (300) surrounding the thermal insulation layer (200); and
an induction heating ring (400), the induction heating ring (400) being arranged in the thermal insulation layer (200) and surrounding the seed crystal (110), and an inner wall of the induction heating ring (400) and an outer wall of the crucible (100) being spaced apart from each other and insulated by the thermal insulation layer (200), wherein
the induction heating ring (400) comprises a first annular portion (410) and a second annular portion (420), the first annular portion (410) surrounds the seed crystal (110), an outer peripheral wall of the second annular portion (420) is connected to a top of the first annular portion (410), and an inner peripheral wall of the second annular portion (420) extends toward an axis of the crucible (100).

2. The apparatus for growing the high-quality silicon carbide crystals according to claim 1, wherein
the crucible (100) comprises a discharge section (102) and a crystal growth section (104) which are connected sequentially from bottom to top, a diameter of the crystal growth section (104) is smaller than that of the discharge section (102), such that the crucible (100) is in a stepped pattern, the induction heating ring (400) surrounds the crystal growth section (104), and the seed crystal (110) is arranged on a top of the crystal growth section (104).

3. The apparatus for growing the high-quality silicon carbide crystals according to claim 1, wherein
an inner diameter of the induction heating ring (400) remains constant or gradually gets increased in a bottom-up direction.

4. The apparatus for growing the high-quality silicon carbide crystals according to claim 1, wherein
a first cavity (500) is formed between the top of the crucible (100) and the thermal insulation layer (200), and the inner peripheral wall of the second annular portion (420) extends into the first cavity (500).

5. The apparatus for growing the high-quality silicon carbide crystals according to claim 4, wherein
the inner peripheral wall of the second annular portion (420) extends to a position above the seed crystal (110).

6. The apparatus for growing the high-quality silicon carbide crystals according to claim 4, wherein
a height of the second annular portion (420) remains constant or gradually gets decreased in a direction from the outer peripheral wall to the inner peripheral wall.

7. The apparatus for growing the high-quality silicon carbide crystals according to claim 1, wherein
the apparatus further comprises an auxiliary heating ring (700), the auxiliary heating ring (700) is positioned below the induction heating ring (400) and surrounds the crucible (100), an inner wall of the auxiliary heating ring (700) is spaced apart from the outer wall of the crucible (100), a second cavity (600) is formed between a lower surface of the crucible (100) and the thermal insulation layer (200), and the auxiliary heating ring (700) is positioned in the second cavity (600).

8. A method for growing high-quality silicon carbide crystals, wherein
based on the apparatus for growing high-quality silicon carbide crystals according to claim 1, the method comprises:
placing silicon carbide powder (800) in the crucible (100);
pumping air from the crucible (100) and then filling inert gases;
energizing the induction coil (300) to heat the crucible (100) so as to raise a temperature inside the crucible (100) to 2000-2600°C;
exhausting the crucible (100) again to reduce a pressure inside the crucible (100) to 0.01-4E3 Pa;
sublimating the silicon carbide powder (800) and starting to grow the silicon carbide crystals on the seed crystal (110);
after the silicon carbide crystals grow for 10-300 h, filling the inert gases into the crucible (100) again to elevate the pressure inside the crucible (100) to 5E3-1E5 Pa; and
at the end of the growth of the silicon carbide crystals, de-energizing the induction coil (300), and taking out the silicon carbide crystals from the crucible (100) after the temperature inside the crucible (100) is reduced to a room temperature.

## Patentansprüche

1. Eine Vorrichtung zum Züchten hochwertiger Siliciumcarbidkristalle, bestehend
ein Tiegel (100), auf dem ein Impfkristall (110) angeordnet ist;
eine Wärmedämmschicht (200), wobei die Wärmedämmschicht (200) an der Außenseite des Tiegels (100) angeordnet ist;
eine Induktionsspule (300), die die Wärmedämmschicht (200) umgibt; und ein Induktionsheizring (400), der in der Wärmedämmschicht (200) angeordnet ist und den Impfkristall (110) umgibt, wobei die Innenwand des Induktionsheizrings (400) und die Außenwand des Tiegels (100) voneinander beabstandet und durch die Wärmedämmschicht (200) isoliert sind, wobei
der Induktionsheizring (400) umfasst einen ersten ringförmigen Abschnitt (410) und einen zweiten ringförmigen Abschnitt (420). Der erste ringförmige Abschnitt (410) umschließt den Impfkristall (110). Eine äußere Umfangswand des zweiten ringförmigen Abschnitts (420) ist mit der Oberseite des ersten ringförmigen Abschnitts (410) verbunden, und eine innere Umfangswand des zweiten ringförmigen Abschnitts (420) erstreckt sich in Richtung einer Achse des Tiegels (100).

2. Die Vorrichtung zum Züchten von hochwertigen Siliciumcarbidkristallen nach Anspruch 1, wobei
der Tiegel (100) besteht aus einem Austragsbereich (102) und einem Kristallwachstumsbereich (104), die von unten nach oben nacheinander verbunden sind. Der Durchmesser des Kristallwachstumsbereichs (104) ist kleiner als der des Austragsbereichs (102), sodass der Tiegel (100) eine stufenförmige Struktur aufweist der Induktionsheizring (400) umschließt den Kristallwachstumsbereich (104), und der Impfkristall (110) ist auf der Oberseite des Kristallwachstumsbereichs (104) angeordnet.

3. Die Vorrichtung zum Züchten der hochwertigen Siliciumcarbidkristalle nach Anspruch 1, wobei
der Innendurchmesser des Induktionsheizrings (400) bleibt konstant oder wird von unten nach oben allmählich vergrößert.

4. Die Vorrichtung zum Züchten von hochwertigen Siliciumcarbidkristallen nach Anspruch 1, wobei
zwischen der Oberseite des Tiegels (100) und der Wärmedämmschicht (200) bildet sich ein erster Hohlraum (500), und die innere Umfangswand des zweiten ringförmigen Abschnitts (420) erstreckt sich in den ersten Hohlraum (500).

5. Die Vorrichtung zum Züchten der hochwertigen Siliciumcarbidkristalle nach Anspruch 4, wobei
die innere Umfangswand des zweiten ringförmigen Abschnitts (420) erstreckt sich bis zu einer Position oberhalb des Impfkristalls (110).

6. Die Vorrichtung zum Züchten der hochwertigen Siliciumcarbidkristalle nach Anspruch 4, wobei
die Höhe des zweiten ringförmigen Abschnitts (420) bleibt konstant oder nimmt in Richtung von der äußeren Umfangswand zur inneren Umfangswand allmählich ab.

7. Die Vorrichtung zum Züchten von hochwertigen Siliciumcarbidkristallen nach Anspruch 1, wobei
die Vorrichtung umfasst ferner einen Hilfsheizring (700), der unterhalb des Induktionsheizrings (400) angeordnet ist und den Tiegel (100) umschließt. Die Innenwand des Hilfsheizrings (700) ist von der Außenwand des Tiegels (100) beabstandet. Zwischen der Unterseite des Tiegels (100) und der Wärmedämmschicht (200) ist ein zweiter Hohlraum (600) ausgebildet, in dem sich der Hilfsheizring (700) befindet.

8. Verfahren zum Züchten hochwertiger Siliciumcarbidkristalle, wobei
das Verfahren, basierend auf der Vorrichtung zum Züchten hochwertiger Siliciumcarbidkristalle gemäß Anspruch 1, umfasst:
Siliciumcarbidpulver (800) in den Tiegel (100) geben;
Luft aus dem Tiegel abpumpen (100) und anschließend Inertgase einfüllen;
erregung der Induktionsspule (300) zum Erhitzen des Tiegels (100) auf eine Temperatur im Inneren des Tiegels (100) von 2000-2600°C;
den Tiegel (100) erneut entleeren, um den Druck im Inneren des Tiegels (100) auf 0,01-4E3 Pa zu reduzieren;
sublimation des Siliciumcarbidpulvers (800) und Beginn des Wachstums der Siliciumcarbidkristalle auf dem Impfkristall (110);
nachdem die Siliciumcarbidkristalle 10-300 Stunden lang gewachsen sind, werden die Inertgase wieder in den Tiegel (100) eingefüllt, um den Druck im Tiegel (100) auf 5E3-1E5 Pa zu erhöhen; und
nach Abschluss des Wachstums der Siliciumcarbidkristalle wird die Induktionsspule (300) stromlos geschaltet und die Siliciumcarbidkristalle aus dem Tiegel (100) entnommen, nachdem die Temperatur im Inneren des Tiegels (100) auf Raumtemperatur gesunken ist.

## Revendications

1. Un appareil pour la croissance de cristaux de carbure de silicium de haute qualité, comprenant
un creuset (100), un cristal germe (110) étant disposé sur le dessus du creuset (100);
une couche d'isolation thermique (200), la couche d'isolation thermique (200) étant disposée sur une face extérieure du creuset (100);
une bobine d'induction (300), la bobine d'induction (300) entourant la couche d'isolation thermique (200); et
un anneau chauffant par induction (400), cet anneau étant disposé dans la couche d'isolation thermique (200) et entourant le germe cristallin (110), la paroi interne de l'anneau chauffant par induction (400) et la paroi externe du creuset (100) étant espacées et isolées par la couche d'isolation thermique (200),
l'anneau de chauffage par induction (400) comprend une première partie annulaire (410) et une deuxième partie annulaire (420), la première partie annulaire (410) entoure le cristal germe (110), une paroi périphérique extérieure de la deuxième partie annulaire (420) est reliée au sommet de la première partie annulaire (410), et une paroi périphérique intérieure de la deuxième partie annulaire (420) s'étend vers un axe du creuset (100).

2. L'appareil pour la croissance de cristaux de carbure de silicium de haute qualité selon la revendication 1, dans lequel
le creuset (100) comprend une section de décharge (102) et une section de croissance cristalline (104) qui sont connectées séquentiellement de bas en haut, le diamètre de la section de croissance cristalline (104) est plus petit que celui de la section de décharge (102), de sorte que le creuset (100) présente un motif étagé, l'anneau de chauffage par induction (400) entoure la section de croissance cristalline (104), et le germe cristallin (110) est disposé au-dessus de la section de croissance cristalline (104).

3. L'appareil pour la croissance de cristaux de carbure de silicium de haute qualité selon la revendication 1, dans lequel
un diamètre intérieur de l'anneau de chauffage par induction (400) reste constant ou augmente progressivement dans une direction ascendante.

4. L'appareil pour la croissance de cristaux de carbure de silicium de haute qualité selon la revendication 1, dans lequel
une première cavité (500) est formée entre le haut du creuset (100) et la couche d'isolation thermique (200), et la paroi périphérique intérieure de la deuxième partie annulaire (420) s'étend dans la première cavité (500).

5. L'appareil pour la croissance de cristaux de carbure de silicium de haute qualité selon la revendication 4, dans lequel
la paroi périphérique interne de la deuxième portion annulaire (420) s'étend jusqu'à une position au-dessus du cristal germe (110).

6. L'appareil pour la croissance de cristaux de carbure de silicium de haute qualité selon la revendication 4, dans lequel
la hauteur de la deuxième portion annulaire (420) reste constante ou diminue progressivement dans une direction allant de la paroi périphérique extérieure à la paroi périphérique intérieure.

7. L'appareil pour la croissance de cristaux de carbure de silicium de haute qualité selon la revendication 1, dans lequel
l'appareil comprend en outre un anneau chauffant auxiliaire (700), l'anneau chauffant auxiliaire (700) est positionné sous l'anneau chauffant par induction (400) et entoure le creuset (100), une paroi intérieure de l'anneau chauffant auxiliaire (700) est espacée de la paroi extérieure du creuset (100), une deuxième cavité (600) est formée entre une surface inférieure du creuset (100) et la couche d'isolation thermique (200), et l'anneau chauffant auxiliaire (700) est positionné dans la deuxième cavité (600).

8. Procédé de croissance de cristaux de carbure de silicium de haute qualité, dans lequel
selon l'appareil de croissance de cristaux de carbure de silicium de haute qualité selon la revendication 1, le procédé comprend:
placer la poudre de carbure de silicium (800) dans le creuset (100);
pompage de l'air du creuset (100) puis remplissage avec des gaz inertes;
alimenter la bobine d'induction (300) pour chauffer le creuset (100) afin d'élever une température à l'intérieur du creuset (100) à 2000-2600°C;
épuiser à nouveau le creuset (100) pour réduire la pression à l'intérieur du creuset (100) à 0,01-4E3 Pa;
sublimant la poudre de carbure de silicium (800) et commençant à faire croître les cristaux de carbure de silicium sur le cristal germe (110);
après la croissance des cristaux de carbure de silicium pendant 10 à 300 h, remplir à nouveau le creuset (100) de gaz inertes pour élever la pression à l'intérieur du creuset (100) à 5E3-1E5 Pa; et
à la fin de la croissance des cristaux de carbure de silicium, débrancher la bobine d'induction (300) et retirer les cristaux de carbure de silicium du creuset (100) après que la température à l'intérieur du creuset (100) soit réduite à la température ambiante.
